# EUROPEAN PATENT SPECIFICATION

(11) **EP 1 402 386 B1**
(45) Date of publication and mention of the grant of the patent: **26.05.2010**
(21) Application number: 02721138.2
(22) Date of filing: 25.02.2002
(51) Int. Cl.: H04L 29/12

(54) **ETHERNET ADDRESSING VIA PHYSICAL LOCATION FOR MASSIVELY PARALLEL SYSTEMS**
ETHERNET-ADRESSIERUNG ÜBER PHYSIKALISCHE POSITION FÜR MASSIV PARALLELE SYSTEME
ADDRESSAGE ETHERNET EN FONCTION D'UN EMPLACEMENT PHYSIQUE POUR SYSTEMES MASSIVEMENT PARALLELES

(30) Priority: 24.02.2001 US 271124 P
(43) Date of publication of application: 31.03.2004
(73) Proprietor: International Business Machines Corporation, Armonk, NY 10504 (US)
(72) Inventor: CHEN, Dong, c/o IBM United Kingdom Limited, Wincheste, Hampshire SO21 2JN (GB); COTEUS, Paul W., Yorktown Heights, NY 10598 (US); GARA, Alan G., Mount Kisco, NY 10549 (US); GIAMPAPA, Mark E., Irvington, NY 10533 (US); TAKKEN, Todd E., c/o IBM United Kingdom Limited, Winchester, Hampshire SO21 2JN (GB)
(74) Representative: Williams, Julian David
(86) International application number: PCT/US2002/005570
(87) International publication number: WO 2002/069096

(56) References cited:
- US-A- 5 835 725
- US-A- 5 956 665
- US-A- 5 964 872
- US-A1- 2001 034 852
- US-B1- 6 223 149
- US-B1- 6 236 652
- US-B1- 6 285 967
- NAVAS ET AL: "GeoCast - geographic addressing and routing" MOBICOM. PROCEEDINGS OF THE ANNUAL INTERNATIONAL CONFERENCE ONMOBILE COMPUTING AND NETWORKING, XX, XX, 26 September 1997 (1997-09-26), pages 66-76, XP002155093

## Description

### FIELD OF THE INVENTION

The present invention broadly relates to a method of assigning addresses to electronic devices. More particularly, it relates to a method of assigning an encoded unique hardware address to a computational device node, where the encoding represents the physical address of the computational device node.

### BACKGROUND OF THE INVENTION

A well known standard for computer data networking, the Open Systems Interconnection (OSI) standard, specifies several layers of interconnection for the purpose of compatible data communications system design. One such layer is the Data Link Layer. This layer represents the transmission medium through which network devices communicate between the layer below it, the Physical Layer where the hardware is connected, and the immediate layer above it, the Network Layer.

OSI specifies several alternate media at the Data Link Layer, one such medium is the Ethernet. Whichever medium is used at the Data Link Layer, must contain a unique hardware address for each device on the network. This unique hardware address, also known as a Medium Access Control (MAC) address is the same as a unique address for the medium used, e.g., an Ethernet address. Therefore, the MAC address of a device and its Ethernet address are the same unique number. As currently generally implemented, for Ethernet, the MAC address is a 48 bit number usually expressed as 12 hexadecimal digits. Under the well known current address mapping scheme, the most significant 6 hexadecimal digits encodes the hardware device manufacturer, e.g. 08005A for IBM. The least significant 6 hexadecimal digits encodes a serial number for the devices manufactured by the hardware device manufacturer.

In a related disclosure of U.S. Provisional Application Serial Number 60/271,124 "A Novel Massively Parallel Supercomputer", therein is described a semiconductor device with two electronic processors within each node of a multi-computer. Within the multi-computer, there is a plurality of high speed internal networks, and an external network employing Ethernet.

In the massively parallel computer system described above, 162,000 different Ethernet addresses are expected to be deployed. This large number of Ethernet addresses creates a significant problem for a host computer, as well as intermediate network routers and switches, all of which must keep track of the MAC address for a variety of purposes including test, diagnostics, initial program loading, etc. For example, if a particular device's MAC address is not responding during a test, the physical location of the device must be determined for further testing and diagnostics. This problem of finding the device is magnified, when as in a massively parallel computer system, many nodes are arranged in many different locations. For example, the supercomputer nodes which are to be assigned MAC addresses are computer chips which physically reside on cards. The cards are mounted on boards called midplanes. The midplanes are in turn mounted in racks. Thus, the rack, midplane, board, card and chip must somehow be isolated when the only thing known about a failed device is its MAC address. While there is no known prior art that associates a physical location to a device's MAC address, it would be desirable to solve this problem by creating such an association.

US 5,956,665 describes a conventional system for mapping computer components in a computer system.

### SUMMARY OF THE INVENTION

Therefore, it is an object of the present invention to provide a method as further defined in claim 1 and device as further defined in claim 7 for uniquely assigning a physical location encoded MAC address to a device.

Further detailed embodiments are defined in the dependent claims.

A further object of the present invention is to provide a method and device for uniquely assigning a physical location encoded MAC address to the device, where the MAC address is encoded by an external interface to the device.

Yet another object of the current invention is to provide a method and device for uniquely assigning a physical location encoded MAC address to the device, where a data link medium is Ethernet, and a corresponding Ethernet address is the same as the encoded MAC address.

A further object of the current invention is to provide a method and device for uniquely assigning a physical location encoded MAC address to the device, where the data link medium is any medium which currently exists or may be developed for communication at the Data Link Layer, and the corresponding data link medium address is the same as the encoded MAC address.

An even further object of the current invention is to provide a method and device for determining the physical location of any of a plurality of interconnected devices for the purpose of testing, diagnostics, program loading and monitoring the devices in a massively parallel system.

These and other objects and advantages may be obtained in the present invention by providing a method and device that encodes a physical location into a MAC address and uniquely assigns the physical location encoded MAC address to a device.

Specifically, there is provided a method for uniquely assigning a MAC address to a device which comprises: configuring device interconnections to encode the MAC address to a physical location of the device; using the encoded MAC address as a unique Ethernet address; using the wiring to encode a predetermined number of unique bits in the MAC address; assigning the predetermined number of unique bits to a value representing hardware device coordinates, such as rack number, midplane number, card number, and chip number to the device physical location.

### BRIEF DESCRIPTION OF THE DRAWINGS

The present invention will now be described in more detail by referring to the drawings that accompany the present application. It is noted that in the accompanying drawings like reference numerals are used for describing like and corresponding elements thereof.
Fig. 1 shows the physical layout of the hardware environment of the present invention;
Fig. 2 shows the compute node interconnections through an Ethernet switch;
Fig. 3 shows the prior art MAC address byte structure;
Fig. 4 shows the MAC address byte structure of the present invention; and
Fig. 5 shows an example of physical address encoding on a mounting surface of the present invention.

An aspect of this invention applies to an external Ethernet based network. A preferred embodiment of this invention encodes a physical location of a node in the Ethernet "MAC" hardware address which is assigned through a combination of the particular Rack containing the Node, the particular midplane containing the node, and the particular node-card containing the node.

In a preferred embodiment of this invention, every Ethernet packet sent by the supercomputer to the host machine uniquely identifies the physical location of the node generating the packet and allows that information to be used to track problems to specific nodes in the machine. Another aspect of this invention can also uniquely identify a geographical location as part of the physical location.

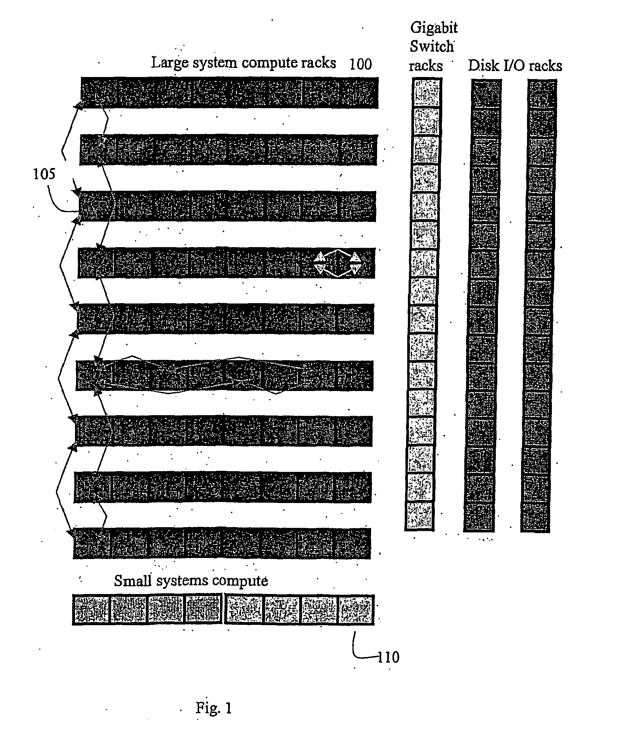

In one aspect of this invention, as shown in the example of Fig. 1, there are physically 80 system compute racks 105, 110. As discussed above, a number of midplanes occupy each rack, for example 2 midplanes per rack. Additionally there are a number of cards, e.g., 64 cards, that occupy each midplane. Each card has a number of network addressable chips, e.g., 9 chips. And, in a preferred aspect of this invention, each network addressable chip on the card represents one of a plurality of compute nodes 205.

According to the above example, the predetermined number of bits needed to represent the physical location of any node is 18 bits. The number of bits is derived by multiplying the locations as follows:

9 chips X 64 cards X 2 midplane X 80 racks = 92,160 unique locations within a system. That number is then converted to hexadecimal which is 16800h, representing 18 bits of information.

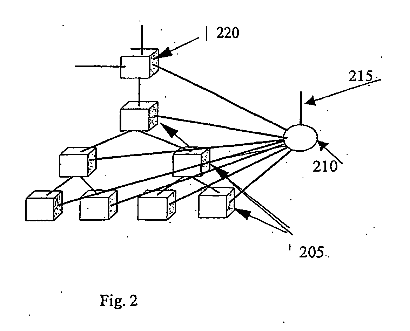

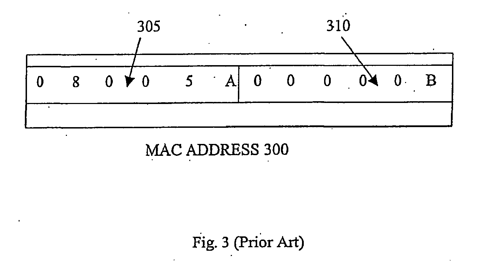

Fig. 2 shows the network environment in which the compute nodes 205 communicate using switch 210 for Ethernet data link 215. Under these conditions, the 48 bit Ethernet MAC address is well suited for carrying the physical location information. As shown in Fig. 3, the 48 bit MAC address is broken down into a most significant part (MSP) 305 and a least significant part (LSP) 310.

The prior art method allocates the MSP to a manufacturer such as IBM as shown, MSP 310 is 08005A for IBM. Under the prior art method, the LSP 310 is allocated for serial numbers.

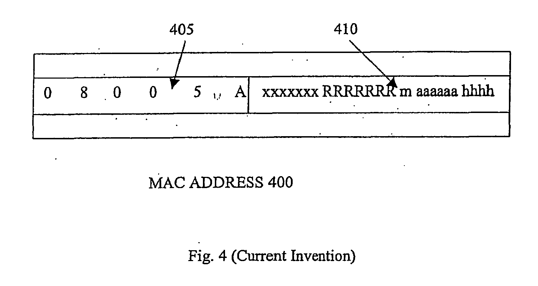

Under the inventive method, the MSP 405 is still reserved for the manufacturer identification, e.g. IBM. However, the LSP is now allocated as a physical location descriptor 410. The physical location descriptor may define a device location such as the location of compute node 205, by rack, midplane, card and chip as described above. The example physical location descriptor 410 is shown to have a 7 R bit field to identify a rack number, a 1 m bit field to identify a midplane, a 6 a bit field to identify a card number, and a 4 h bit field to identify a computing device number. Thus, as shown, the physical location of a node is completely described. Moreover, the x bits shown in the LSP, Fig. 4 are extra bits which could be used to describe device, e.g., node physical location in an even larger physical topology.

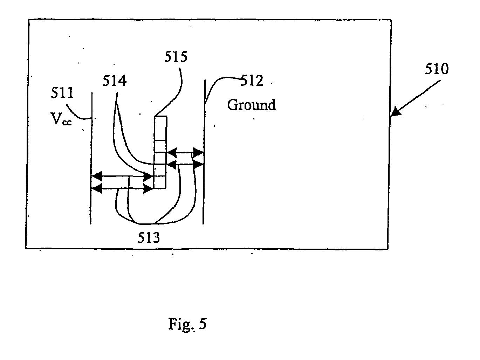

A preferred aspect of the present invention uses a hard wired programming technique to encode physical location, such as shown in the example in Fig. 5. It should be noted that while wiring is discussed and shown here, any means of configuring device interconnections, such as optoelectronic means, for example, may be employed within the scope of the present invention. A mounting surface 510, e.g., a midplane has a slot connector 515 with connections 513 going to either a positive voltage, V_{cc} 511 or ground 512. In this manner, the voltage levels may be used to encode a predetermined number of bits corresponding to the physical topology of the interfaces. In a similar fashion, the card could be wired to encode a chip position number for each chip, i.e., node on the card. Also system level wiring connecting the racks together could be configured to encode a rack number that gets propagated through the midplane, and on to the card. Similarly, rack level wiring is configured to encode a midplane number, while midplane wiring is configured to encode a card number. Finally, card level wiring could be configured to identify, i.e., encode a compute node number. When power is applied to the system, an electrically erasable programmable read only memory (EEPROM) (not shown) could be used to store the encoded bits for configuration of the MAC address for the connected device, e.g. node.

An alternative technique for entering the physical location encoding bits into the device or node would be to program the physical location encoded MAC address for each node by using that node's IEEE 1149.1 JTAG interface. It is known in the art that communication with a JTAG-compliant device, such as any of compute nodes 205 is achieved by utilizing a host computer, such as for example, a hardware controller that has a connection to a JTAG-compliant card containing the compute nodes 205. The JTAG-compliant devices, e.g., compute nodes must connect to all flash memory address, data and control signals. Flash memory does not need to be JTAG-compliant for this programming method to function. The host computer sends commands and data to the JTAG-compliant device, e.g., any of compute nodes 205, then propagates the data to the flash memory for programming. In this manner, the host computer provides a communication link with any of the compute nodes 205 for accomplishing the physical location encoding of the MAC address. The JTAG capabilities of a preferred environment of this invention are discussed in the provisional application 60/271,124.

During system operation, a MAC address transmitted by a connected device as described above may be interrogated by switches, network monitors, and host computers to determine the exact physical location of the device. This capability provides for improved management, diagnostics and debug functionality of the parallel computing system. Additionally, when TCP/IP addresses are assigned, such as in a system running the Dynamic Host Configuration Protocol (DHCP), the TCP/IP address becomes an equally valid indicator of the device location.

Now that the invention has been described by way of a preferred embodiment, various modifications and improvements will occur to those of skill in the art. Thus, it should be understood that the preferred embodiment is provided as an example and not as a limitation. The scope of the invention is defined by the appended claims.

## Claims

1. A method for uniquely assigning a MAC address (400) to a computing device in a node (205) of a massively parallel computing system comprising a plurality of such nodes, **characterized in that** the method comprises:
programming the computing device to encode a physical location of the computing device in the MAC address;
using a predetermined number of bits (410) of the MAC address for the encode step, wherein the physical location of the computing device is uniquely described.

2. The method of Claim 1, wherein the programming of the computing device is based on a predetermined wiring configuration of a unique rack (105), midplane, and card containing the computing device.

3. The method of Claim 1, wherein the programming of the computing device is based on instructions from a host computer.

4. The method of Claim 1, wherein the predetermined number of bits of the MAC address comprises a least significant part of the MAC address.

5. The method of Claim 4, wherein the least significant part of the MAC address includes a physical location descriptor, comprising:
a compute rack field;
a midplane field;
a card field; and
a computing device field.

6. The method of Claim 1, further comprising:
using the MAC address for management of the parallel computing system;
using the MAC address for diagnostics of the parallel computing system; and
using the MAC address for debug functions of the parallel computing system.

7. Apparatus for uniquely assigning a MAC address (400) to a computing device in a node (205) of a massively parallel computing system comprising a plurality of such nodes, **characterized in that** the apparatus comprises:
a) a system interconnect configuration, creating a compute rack encoded position of a compute rack location relative to a plurality of compute racks (105) in the massively parallel computing system, wherein the compute rack encoded position is used to program a predetermined number of bits (410) in a compute rack field of the MAC address of the computing device for uniquely describing the compute rack location of the computing device.
b) a compute rack interconnect configuration, creating a midplane encoded position of a midplane location relative to a plurality of midplanes connected to the compute rack, wherein the midplane encoded position is used to program a predetermined number of bits in a midplane field of the MAC address of the computing device for uniquely describing the midplane location of the computing device.
c) a midplane interconnect configuration, creating a card encoded position of a card location relative to a plurality of cards connected to the midplane, wherein the card encoded position is used to program a predetermined number of bits in a card field of the MAC address of the computing device for uniquely describing the card location of the computing device.
d) a card interconnect configuration, creating a computing device encoded position of a computing device location relative to a plurality of computing devices connected to the card, wherein the computing device encoded position is used to program a predetermined number of bits in a computing device field of the MAC address of the computing device for uniquely describing the computing device location on the card.

8. The apparatus of Claim 7, wherein the MAC address is uniquely associated with an Ethernet address, and the Ethernet address is uniquely associated with a TCP/IP address.

9. The apparatus of Claim 7, wherein a least significant part of the MAC address comprises the compute rack field, the midplane field, the card field, and the computing device field.

10. The apparatus of Claim 7, comprising:
means for using the MAC address for management of the parallel computing system;
means for using the MAC address for diagnostics of the parallel computing system; and
means for using the MAC address for debug functions of the parallel computing system.

## Patentansprüche

1. Verfahren, das dazu dient, einer Datenverarbeitungseinheit in einem Knoten (205) eines massiv-parallelen Datenverarbeitungssystems, das eine Vielzahl solcher Knoten umfasst, eine MAC-Adresse (400) eindeutig zuzuweisen, **dadurch gekennzeichnet, dass** das Verfahren Folgendes umfasst:
Programmieren der Datenverarbeitungseinheit in der Weise, dass eine physische Position der Datenverarbeitungseinheit in der MAC-Adresse codiert wird;
Verwenden einer vorher festgelegten Anzahl von Bits (410) der MAC-Adresse für den Schritt des Codierens, wobei die physische Position der Datenverarbeitungseinheit eindeutig beschrieben wird.

2. Verfahren nach Anspruch 1, wobei die Programmierung der Datenverarbeitungseinheit auf einer vorher festgelegten Verdrahtungskonfiguration eines bestimmten Mittelebenen-Einschubs (rack, midplane) (105) und einer Karte beruht, welche die Datenverarbeitungseinheit enthält.

3. Verfahren nach Anspruch 1, wobei die Programmierung der Datenverarbeitungseinheit auf Befehlen von einem Hostrechner beruht.

4. Verfahren nach Anspruch 1, wobei die vorher festgelegte Anzahl von Bits der MAC-Adresse einen niedrigstwertigen Teil der MAC-Adresse umfasst.

5. Verfahren nach Anspruch 4, wobei der niedrigstwertige Teil der MAC-Adresse einen Deskriptor der physischen Position enthält, der Folgendes umfasst:
ein Datenverarbeitungseinschub-Feld (compute rack field); ein Mittelebenen-Feld (midplane field);
ein Karten-Feld; und
ein Datenverarbeitungseinheiten-Feld.

6. Verfahren nach Anspruch 1, das des Weiteren Folgendes umfasst:
Verwenden der MAC-Adresse zur Verwaltung des parallelen Datenverarbeitungssystems;
Verwenden der MAC-Adresse zum Diagnostizieren des parallelen Datenverarbeitungssystems; und
Verwenden der MAC-Adresse für Funktionen zum Aufspüren und zum Beseitigen von Fehlern des parallelen Datenverarbeitungssystems.

7. Vorrichtung die dazu dient, einer Datenverarbeitungseinheit in einem Knoten (205) eines massiv-parallelen Datenverarbeitungssystems, das eine Vielzahl solcher Knoten umfasst, eine MAC-Adresse (400) eindeutig zuzuweisen, **dadurch gekennzeichnet, dass** die Vorrichtung Folgendes umfasst:
a) eine System-Verdrahtungskonfiguration, die eine in einem Datenverarbeitungseinschub codierte Position einer Lage eines Datenverarbeitungseinschubs in Bezug auf eine Vielzahl von Datenverarbeitungseinschüben (105) in dem massiv-parallelen Datenverarbeitungssystem erzeugt, wobei die in einem Datenverarbeitungseinschub codierte Position zur Programmierung einer vorher festgelegten Anzahl von Bits (410) in einem Datenverarbeitungseinschub-Feld der MAC-Adresse der Datenverarbeitungseinheit verwendet wird, um die Position des Datenverarbeitungseinschubs der Datenverarbeitungseinheit eindeutig zu beschreiben;
b) eine Datenverarbeitungseinschub-Verdrahtungskonfiguration, die eine in einer Mittelebene codierte Position einer Lage einer Mittelebene in Bezug auf eine Vielzahl von mit dem Datenverarbeitungseinschub verbundenen Mittelebenen erzeugt, wobei die in der Mittelebene codierte Position zur Programmierung einer vorher festgelegten Anzahl von Bits in einem Mittelebenen-Feld der MAC-Adresse der Datenverarbeitungseinheit verwendet wird, um die Position der Mittelebene der Datenverarbeitungseinheit eindeutig zu beschreiben;
c) eine Mittelebenen-Verdrahtungskonfiguration, die eine auf einer Karte codierte Position einer Lage einer Karte in Bezug auf eine Vielzahl von mit der Mittelebene verbundenen Karten erzeugt, wobei die auf der Karte codierte Position zur Programmierung einer vorher festgelegten Anzahl von Bits in einem Karten-Feld der MAC-Adresse der Datenverarbeitungseinheit verwendet wird, um die Position der Karte der Datenverarbeitungseinheit eindeutig zu beschreiben;
d) eine Karten-Verdrahtungskonfiguration, die eine von einer Datenverarbeitungseinheit codierte Position einer Lage einer Datenverarbeitungseinheit in Bezug auf eine Vielzahl von mit der Karte verbundenen Datenverarbeitungseinheiten erzeugt, wobei die auf der Datenverarbeitungseinheit codierte Position zur Programmierung einer vorher festgelegten Anzahl von Bits in einem Datenverarbeitungseinheiten-Feld der MAC-Adresse der Datenverarbeitungseinheit verwendet wird, um die Position der Datenverarbeitungseinheit auf der Karte eindeutig zu beschreiben.

8. Vorrichtung nach Anspruch 7, wobei die MAC-Adresse einer Ethernet-Adresse eindeutig zugeordnet ist und wobei die Ethernet-Adresse einer TCP/IP-Adresse eindeutig zugeordnet ist.

9. Vorrichtung nach Anspruch 7, wobei ein niedrigstwertiger Teil der MAC-Adresse das Datenverarbeitungseinschub-Feld, das Mittelebenen-Feld, das Karten-Feld und das Datenverarbeitungseinheiten-Feld umfasst.

10. Vorrichtung nach Anspruch 7, die Folgendes umfasst:
ein Mittel, um die MAC-Adresse zur Verwaltung des parallelen Datenverarbeitungssystems zu verwenden;
ein Mittel, um die MAC-Adresse zum Diagnostizieren des parallelen Datenverarbeitungssystems zu verwenden; und
ein Mittel, um die MAC-Adresse für Funktionen zum Aufspüren und Beseitigen von Fehlern des parallelen Datenverarbeitungssystems zu verwenden.

## Revendications

1. Procédé d'affectation de manière unique d'une adresse MAC (400) à un dispositif informatique dans un noeud (205) d'un système informatique massivement parallèle comprenant une pluralité de tels noeuds, **caractérisé en ce que** le procédé comprend :
la programmation du dispositif informatique pour coder une localisation physique du dispositif informatique dans l'adresse MAC,
l'utilisation d'un nombre prédéterminé de bits (410) de l'adresse MAC pour l'étape de codage, où la localisation physique du dispositif informatique est décrite de manière unique.

2. Procédé selon la revendication 1, dans lequel la programmation du dispositif informatique est basée sur une configuration de câblage prédéterminée d'un bâti unique (105), d'un fond de panier, et d'une carte contenant le dispositif informatique.

3. Procédé selon la revendication 1, dans lequel la programmation du dispositif informatique est basée sur des instructions provenant d'un ordinateur hôte.

4. Procédé selon la revendication 1, dans lequel le nombre prédéterminé de bits de l'adresse MAC comprend une partie moins significative de l'adresse MAC.

5. Procédé selon la revendication 4 dans lequel la partie moins significative de l'adresse MAC comprend un descripteur de localisation physique, comprenant :
un champ de bâti informatique,
un champ de fond de panier,
un champ de carte, et
un champ de dispositif informatique.

6. Procédé selon la revendication 1, comprenant en outre :
l'utilisation de l'adresse MAC pour la gestion du système informatique parallèle,
l'utilisation de l'adresse MAC pour le diagnostic du système informatique parallèle, et
l'utilisation de l'adresse MAC pour des fonctions de débogage du système informatique parallèle.

7. Dispositif destiné à affecter de manière unique une adresse MAC (400) à un dispositif informatique dans un noeud (205) d'un système informatique massivement parallèle comprenant une pluralité de tels noeuds, **caractérisé en ce que** le dispositif comprend :
a) une configuration d'interconnexion de système, créant une position codée de bâti informatique d'une localisation de bâti informatique par rapport à une pluralité de bâtis informatiques (105) dans le système informatique massivement parallèle, où la position codée de bâti informatique est utilisée pour programmer un nombre prédéterminé de bits (410) dans un champ de bâti informatique de l'adresse MAC du dispositif informatique pour décrire de manière unique la localisation de bâti informatique du dispositif informatique.
b) une configuration d'interconnexion de bâti informatique, créant une position codée de fond de panier d'une localisation de fond de panier par rapport à une pluralité de fonds de panier connectés au bâti informatique, où la position codée de fond de panier est utilisée pour programmer un nombre prédéterminé de bits dans un champ de fond de panier de l'adresse MAC du dispositif informatique pour décrire de manière unique la localisation de fond de panier du dispositif informatique.
c) une configuration d'interconnexion de fond de panier, créant une position codée de carte d'une localisation de carte par rapport à une pluralité de cartes connectées au fond de panier, où la position codée de carte est utilisée pour programmer un nombre prédéterminé de bits dans un champ de carte de l'adresse MAC du dispositif informatique pour décrire de manière unique la localisation de carte du dispositif informatique.
d) une configuration d'interconnexion de carte, créant une position codée de dispositif informatique d'une localisation de dispositif informatique par rapport à une pluralité de dispositifs informatiques connectés à la carte, où la position codée de dispositif informatique est utilisée pour programmer un nombre prédéterminé de bits dans un champ de dispositif informatique de l'adresse MAC du dispositif informatique pour décrire de manière unique la localisation de dispositif informatique sur la carte.

8. Dispositif selon la revendication 7, dans lequel l'adresse MAC est associée de manière unique à une adresse Ethernet, et l'adresse Ethernet est associée de manière unique à une adresse TCP/IP.

9. Dispositif selon la revendication 7, dans lequel une partie moins significative de l'adresse MAC comprend le champ de bâti informatique, le champ de fond de panier, le champ de carte, et le champ de dispositif informatique.

10. Dispositif selon la revendication 7, comprenant :
un moyen destiné à utiliser l'adresse MAC pour la gestion du système informatique parallèle,
un moyen destiné à utiliser l'adresse MAC pour le diagnostic du système informatique parallèle, et
un moyen destiné à utiliser l'adresse MAC pour des fonctions de débogage du système informatique parallèle.
